Europäisches Patentamt

European Patent Office

Office européen des brevets

(19)

(11) Numéro de publication: **0 237 099**

**A1**

(12) **DEMANDE DE BREVET EUROPEEN**

(21) Numéro de dépôt: **87200294.4**

(51) Int. Cl.⁴: **H03F 3/60**

(22) Date de dépôt: **23.02.87**

(30) Priorité: **28.02.86 FR 8602823**

(43) Date de publication de la demande:
**16.09.87 Bulletin 87/38**

(84) Etats contractants désignés:
**DE FR GB**

(71) Demandeur: **Laboratoires d'Electronique et de Physique Appliquée L.E.P.
3, Avenue Descartes
F-94450 Limeil-Brévannes(FR)
FR**
Demandeur: **N.V. Philips'
Gloeilampenfabrieken
Groenewoudseweg 1
NL-5621 BA Eindhoven(NL)
DE GB**

(72) Inventeur: **Gamand, Patrice
Société SPID 209 Rue de L'Université
F-75007 Paris(FR)**

(74) Mandataire: **Landousy, Christian et al
Société Civile S.P.I.D. 209, Rue de
l'Université
F-75007 Paris(FR)**

(54) **Circuit amplificateur distribué large bande dans le domaine des hyperfréquences.**

(57) Circuit amplificateur distribué large bande constitué de plusieurs transistors à effet de champ ($T_1$-$T_8$) dont les grilles sont connectées à des inductances ($L_1$-$L_8$) de manière à former une ligne de transmission dite ligne de grille ($L_G$), dont les drains sont connectés à des inductances ($L_{11}$-$L_{18}$) de manière à former une ligne de transmission dite ligne de drain ($L_D$, et dont les sources sont reliées à la masse, la distribution des étages le long de la ligne de grille et de drain étant faite de manière telle que ces lignes de grille ($L_G$) et de drain ($L_D$) sont périodiquement chargées par leur propre impédance et par les capacités de grille et de drain des transistors ($T_1$-$T_8$) constituant ainsi des lignes dites artificielles, et telle qu'un signal d'entrée hyperfréquences est appliqué sur l'entrée (E) de la ligne de grille($L_G$) et un signal de sortie hyperfréquences amplifié est prélevé sur la sortie (S) de la ligne de drain ($L_D$), les extrémités des lignes de grille et de drain opposées aux entrées-sorties (E,S) étant fermées sur des charges ($C_D$, $C_G$), et au moins une de ces extrémités de ligne comportant un circuit de polarisation (P), caractérisé en ce que l'extrémité de la ligne de drain ($L_D$) opposée à la sortie (S) est seule munie de moyens de polarisations (P) tandis que l'extrémité de la ligne de grille ($L_G$) opposée à l'entrée (E) est munie de moyens (LM) pour compenser les variations de l'impédance caractéristique des lignes artificielles en fonction de la fréquence.

EP 0 237 099 A1

FIG.1

# CIRCUIT AMPLIFICATEUR DISTRIBUE LARGE BANDE DANS LE DOMAINE DES HYPERFREQUENCES

L'invention concerne un circuit amplificateur distribué large bande, cet amplificateur étant constitué de plusieurs transistors à effet de champ dont les grilles sont connectées à des inductances de manière à former une ligne de transmission dite ligne de grille, dont les drains sont connectés à des inductances de manière à former une ligne de transmission dite ligne de drain, et dont les sources sont reliées à la masse, la distribution des étages le long de la ligne de grille et de drain étant faite de manière telle que ces lignes de grille et de drain sont périodiquement chargées par leur propre impédance et par les capacités de grille et de drain des transistors constituant ainsi des lignes dites artificielles, et telle qu'un signal d'entrée hyperfréquences est appliqué sur l'entrée de la ligne de grille et un signal de sortie hyperfréquences amplifié est prélevé sur la sortie de la ligne de drain, les extrémités des lignes de grille et de drain opposées aux entrées-sorties étant fermées sur des charges, et au moins une de ces extrémités de ligne comportant un circuit de polarisation.

L'invention trouve son application dans la réalisation d'amplificateurs intégrés sur substrat semiconducteurs du groupe III-V fonctionnant dans le domaine des hyperfréquences, sur une large bande, par exemple entre 2 et 30 GHz et au-delà.

Un tel amplificateur distribué est connu par la publication dans IEEE Transaction on Microwave Theory and Techniques, Vol MTT-32, N°1, January 1984, de l'article intitulé "2-20 GHz GaAs Traveling-Wave Amplifier" par YALCIN AYASLI et alii, p. 71 à 78.

Selon le document cité, cet amplificateur est formé d'une pluralité d'étages montés en cascade. Chaque étage comprend un transistor à effet de champ, dont les capacités d'entrées et de sorties sont combinées avec des inductances pour former respectivement une ligne d'entrée et une ligne de sortie. Ces inductances sont du type microruban et sont donc chargées périodiquement par les impédances de grille et de drain présentées par le tranistor à effet de champ.

Un tel circuit possède la propriété d'être très large bande, s'étendant au domaine hyperfréquences, et d'être intégrable par exemple sur arséniure de gallium.

Mais tel que décrit dans le document cité, cet amplificatuer présente certains inconvénients. En particulier, sa fréquence maximale de fonctionnement est limitée du fait des circuits de polarisation qui dégradent les performances. Selon le document cité ce problème est résolu au mieux par des circuits de polarisation de grille et de drain sophistiqués placés aux extrémités des lignes artificielles de transmission et constitués de tronçons de lignes et de capacités formant des circuits LC.

Cependant, lorsque l'homme du métier se propose de réaliser le circuit préconisé par le document cité, il apparaît que, en dépit de cette amélioration des circuits de polarisation, des réflexions multiples se produisent aux extrémités des lignés de grille et de drain limitant encore la bande passante de cet amplificateur. Du fait du couplage entre la ligne de grille et la ligne de drain dû aux capacités grille-drain des transistors, ces réflexions perturbent la propagation le long des lignes de grille et de drain. Il apparaît en outre que les variations des impédances caractéristiques des lignes artificielles de transmission avec la fréquence ne peuvent être compensées exactement par une simple amélioration des circuits incluant les polarisations.

C'est pourquoi la présente invention propose un circuit amplificateur distribué, qui est dépourvu de ces inconvénients.

Selon l'invention ce but est atteint à l'aide d'un circuit amplificateur distribué tel que décrit dans le préambule, caractérisé en ce que l'extrémité de la ligne de drain opposée à la sortie est munie de moyens de polarisation tandis que l'extrémité de la ligne de grille opposée à l'entrée est munie de moyens pour compenser les variations de l'impédance caractéristique des lignes artificielles en fonction de la fréquence. Le circuit amplificateur distribué présente alors, entre autres, les avantages suivants :

-les variations d'impédance caractéristique, en fonction de la fréquence, des lignes de transmission artificielles (constituées d'inductances associées aux capacités de grille et de drain des transistors) sont compensées. Ceci est un facteur prépondérant dans l'amélioration des caractéristiques des amplificateurs distribués en termes de bande passante et ondulation du gain ;

-les réflexions multiples dues à ces variations sont diminuées ;

-la polarisation de grille et de drain des transistors est réalisée au mieux ;

-l'effet du couplage entre les lignes de grille et de drain, dû aux capacités grille-drain des transistors est diminué ;

-l'ondulation du gain, causée par des perturbations de la propagation des ondes le long des lignes de transmission, est considérablement réduite ;

-la bande passante qui était, dans l'état de la technique, largement inférieure à la fréquence de coupure des lignes artificielles est augmentée ;

-les transistors sont utilisés dans de meilleures conditions et au maximum de leur capacité.

On notera que l'amplificateur distribué réalisé selon l'invention permet d'atteindre des fréquences aussi élevées que 30 GHz et plus, ce qui est bien supérieur à ce qui est obtenu à l'aide du circuit considéré comme état de la technique, dont la fréquence de coupure était de l'ordre de 20 GHz.

L'invention sera mieux comprise à l'aide de la description suivante illustrée par les figures annexées dont :

-la figure 1 qui représente le circuit amplificateur selon l'invention ;

-la figure 2 qui représente le gain en dB en fonction de la fréquence, obtenu à l'aide du circuit amplificateur selon l'invention.

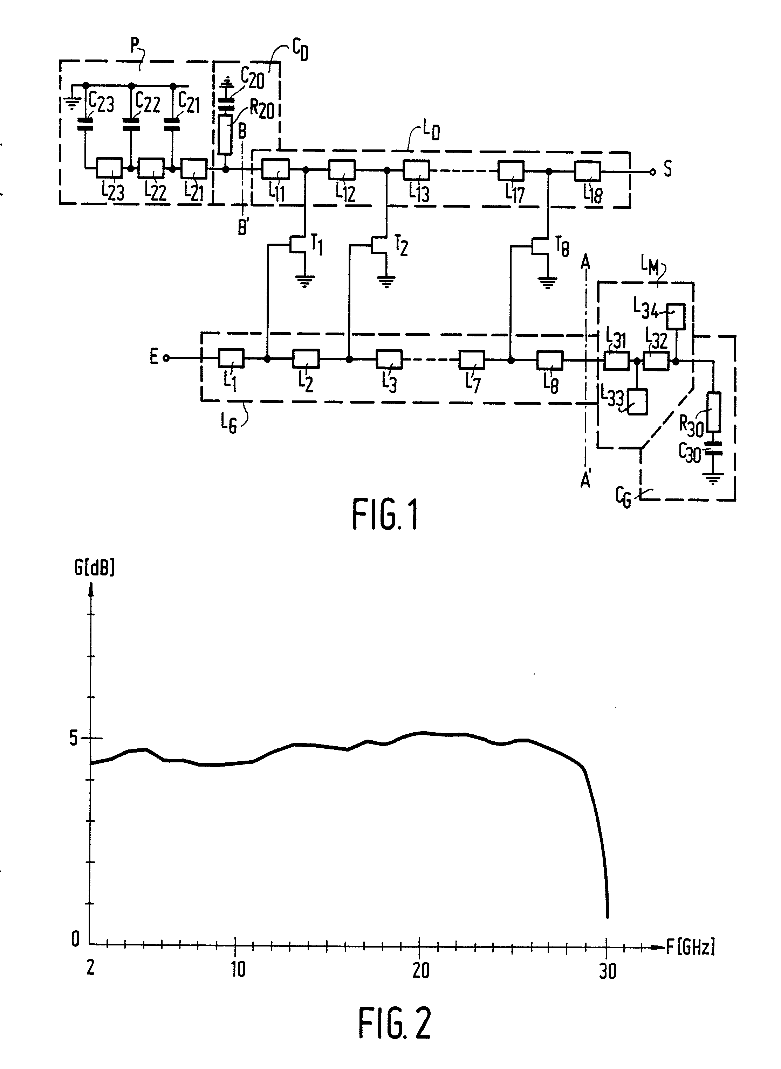

Tel que représenté sur la figure 1, l'amplificateur distrubué, conforme à l'invention comprend une pluralité de transistors à effet de champ $T_1$, $T_2$... etc... montés en source commune, une première ligne $L_G$ formée de tronçons de lignes hyperfréquences $L_1$, $L_2$...etc d'impédances $LG_1$, $LG_2$... respectivement, et une seconde ligne $L_D$ formée de tronçons de lignes hyperfréquences $L_{11}$, $L_{12}$,...etc, d'impédances $LD_{11}$, $LD_{12}$... respectivement.

Les grilles des transistors $T_1$, $T2$... sont connectées de façon périodique à la ligne $L_G$ dite ligne de grille, entre les tronçons de lignes hyperfréquences $L_1$, $L_2$... respectivement.

Les drains des transistors $T_1$, $T_2$... sont connectés de façon périodique à la ligne $L_D$ dite ligne de drain, entre les tronçons de lignes hyperfréquences $L_{11}$, $L_{12}$... respectivement.

Un signal d'entrée E hyperfréquences est appliqué à cet amplificateur sur l'extrémité de la ligne de grille $L_G$ et la sortie S hyperfréquences amplifiée est prélevée sur l'extrémité de la ligne de drain.

Les impédances prores $L_1$, $L_2$,... de la ligne de grille $L_G$ forment avec les capacités intrinsèques grille-source des transistors à effet de champ $T_1$, $T_2$,... une ligne hyperfréquences distribuée dite ligne de transmission artificielle.

Il en est de même pour la ligne de drain $L_D$, entre les impédances propres $L_{11}$, $L_{12}$... et les capacités drain-source des transistors à effet de champ $T_1$, $T_2$....

Le principe de fonctionnement de l'amplificateur distribué est basé sur la propagation des signaux le long des lignes de transmission artificielles ainsi constituées. Lorsque le signal hyperfréquence E est appliqué sur la ligne grille, il se propage en excitant chaque transistor qui fournit alors une puissance de sortie capable de se propager sur la ligne drain. Si la vitesse de phase des deux lignes de transmissions artificielles est identique, la puissance s'additionne en phase lors de la propagation le long de la ligne drain.

Il est alors possible d'obtenir une amplification dans une bande de fréquence limitée entre autres par la fréquence de coupure des lignes de transmision.

Lorsque l'amplificateur fonctionne à différentes fréquences dans le domaine des hyperfréquences, il est clair que les tronçons $L_1$, $L_2$, $L_{11}$, $L_{12}$... peuvent représenter des petites sections de lignes de transmission pour des fréquences telles que 2 GHz, alors que ces mêmes tronçons peuvent atteindre une dimension de l'ordre de grandeur d'une longueur d'onde pour des fréquences telles que 20 GHz. La longueur de ces tronçons est calculées de manière à assurer le déphasage nécessaire au bon fonctionnement de l'amplificateur.

L'amplificateur comprend en outre au moins un circuit de polarisation. Selon l'art antérieur, la limitation due aux circuits de polarisation peut être évitée par l'application d'un dispositif de polarisation plus sophistiqué aux extrémités des lignes opposées aux entrées et sorties.

Selon l'invention, un tel circuit de polarisation P est prévu à l'extrémité de la ligne $L_D$ opposée à la sortie S. Ce circuit de polarisation P est constitué de tronçons de lignes de transmission hyperfréquences, $L_{21}$, $L_{22}$, $L_{23}$... et de capacités $C_{21}$, $C_{22}$, $C_{23}$ montées entre la masse et les noeuds de liaisons entre chacun de ces tronçons $L_{21}$, $L_{22}$, $L_{23}$....

Les lignes $L_G$ et $L_D$ sont en outre fermées sur une charge respectivement $C_G$ et $C_D$.

La charge appliquée à la ligne de grille $L_G$ est formée d'une résistance $R_{30}$ et d'une capacité $C_{30}$ montées en série et placées entre la sortie de la ligne $L_G$ et la masse.

Cependant selon l'invention un tel montage peut encore être amélioré.

En effet la fréquence de fonctionnement d'un tel amplificateur distribué est limitée théoriquement d'une part par la fréquence de coupure des transistors à effet de champ, et d'autre part par la fréquence de coupure des lignes artificielles.

En fait, la fréquence de coupure réelle du circuit est bien inférieure à ces fréquences théoriques, car cette fréquence de coupure est limitée par les réflexions multiples et des phénomènes de résonnances qui en découlent. On a vu que ces phénomènes sont dus à la variations des impédances caractéristiques des lignes lorsque la fréquence de fonctionnement varie, et que la seule amélioration de la polarisation ne suffit pas pour supprimer ces phénomènes. Ces phénomènes de réflexions apparaissent en particulier sur la ligne de grille, au niveau du plan AA', l'onde sur la ligne de grille se propageant de l'entrée E en direction de la charge $C_G$.

Sur la ligne de drain, une partie de l'onde se dirige vers la sortie S et une autre partie de l'onde se dirige vers le plan BB'. Mais cette dernière onde incidente arrivant sur BB' est très atténuée, si bien que les réflexions sont très faibles et ne nécessitent pas l'adjonction d'un circuit de compensation.

Selon l'invention, la variation des impédances des lignes est compensée par un circuit $L_M$ placé sur la ligne de grille $L_G$ entre l'extrémité opposée à l'entrée et la charge $C_G$, au niveau du plan AA'.

Ce circuit de compensation d'impédance $L_M$ est formé de deux tronçons de lignes hyperfréquences $L_{31}$ et $L_{32}$ placées en série dans le prolongement de la ligne $L_G$, et d'au moins une ligne ouverte $L_{33}$ par exemple reliée à la ligne $L_G$ entre les tronçons $L_{31}$ et $L_{32}$.

De façon préférentielle une seconde ligne ouverte $L_{34}$ est également adjointe à ce circuit $L_M$ et reliée à la ligne $L_G$ entre le tronçon $L_{32}$ et la charge $C_G$.

Le circuit $L_M$ analysé séparément présente à son entrée (dans le plan AA') une impédance dont le comportement fréquentiel est identique à celui des impédances caractéristiques des lignes de grille et de drain.

De cette façon, les variations d'impédance en fonction de la fréquence sont compensées, les phénomènes de résonance dus aux réflexions multiples sont supprimés, l'effet de couplage entre les lignes est atténué et les avantages décrits sont alors réellement obtenus.

L'amélioration de la polarisation devient alors efficace : les transistors travaillent dans de meilleures conditions.

L'ensemble de ces améliorations permet d'obtenir un élargissement de la bande passante dont la fréquence de coupure se rapproche alors de la fréquence de coupure théorique, avec une ondulation sur le gain diminuée.

On notera que dans un amplificateur distribué tel que selon l'invention le tronçon de ligne placée sur le drain du transistor $T_1$ dans la position $L_{11}$, ne fait pas partie de la charge $C_D$ mais bien de la ligne de drain $L_D$. De même le tronçon de ligne placé sur la grille du transistor $T_8$ dans la position de $L_8$, ne fait pas partie de la charge $C_G$, mais bien de la ligne de grille $L_G$. Ceci est dû au principe même de fonctionnement d'un amplificateur distribué.

En conséquence, on notera que, bien que dans le document cité comme état de l'art, il est dit que des charges plus sophistiquées sont élaborées en tenant compte de ces tronçons d'extrémité des lignes artificielles, une telle affirmation ne peut être en fait soutenue, car elle n'est pas en cohérence avec le principe théorique de fonctionnement d'un tel amplificateur.

Dans un exemple de réalisation, l'amplificateur distribué selon l'invention est formé d'un nombre de 8 transistors à effet de champ. Les tronçons de lignes de transmission sont du type microruban.

Les dimensions des longueurs L de grille des transistors, des largeurs $l$ de grille des transistors, leur tension de pincement $V_T$, la largeur W des lignes de transmission, la longueur $\lambda$ des lignes de transmission sont données dans le tableau I suivant.

Ce circuit est réalisé sur un substrat d'épaisseur e = 250μm et de permitivité $\epsilon$ = 9,6, par exemple en céramique, et en particulier en alumine. Les transistors sont du type implanté réalisés par exemple sur un substrat semi-isolant du groupe III-V tel que l'arséniure de gallium. Les électrodes des transistors peuvent être reliées aux lignes par des fils ultra-courts de manière telle que l'ensemble des transistors et des lignes est supporté par un substrat isolant commun, complètement autonome et dépourvu de polarisation extérieure.

Dans un autre exemple de réalisation, l'ensemble des transistors et des inductances formant les lignes peut être intégré monolithiquement sur un substrat en un composé du groupe III-V tel que l'arséniure de gallium.

4

## TABLEAU I

| Transistors AsGa 6 doigts élémentaires | $\ell$ | L | $V_T$ | Type |
|---|---|---|---|---|
| $T_1$.... $T_8$ | 75 µm | 0,5 µm | 3V | Type N implanté |

| Lignes de transmission | W | | |
|---|---|---|---|
| $L_{12}$, $L_{13}$... $L_{17}$ | 50 µm | 545 µm | |
| $L_2$,... $L_7$ | 50 µm | 300 µm | |
| $L_{11}$ et $L_{18}$ | 50 µm | 545/2 µm | |
| $L_1$ et $L_8$ | 50 µm | 150 µm | |
| $L_{31}$ | 50 µm | 146 µm | |
| $L_{32}$ | | 110 µm | |
| $L_{33}$ | | 600 µm | |
| $L_{34}$ | | 900 µm | |

| Polarisation de drain | W | $\ell$ | Capacité |
|---|---|---|---|
| $L_{21}$ | 30 µm | 2150 µm | |
| $L_{22}$ | 30 µm | 1310 µm | |
| $L_{23}$ | 30 µm | 370 µm | |
| $C_{21}$, $C_{22}$, $C_{23}$ | | | 47 pF |

| Charges | Résistances . | | Capacités |
|---|---|---|---|
| $R_{20}$ | 40 $\Omega$ | | |
| $C_{20}$ | | | 47 pF |
| $R_{30}$ | 53,4 $\Omega$ | | |
| $C_{30}$ | | | 47 pF |

A l'aide du montage décrit précédemment et jugé de configuration préférable, la courbe du gain en fonction de la fréquence, représentée sur la figure 2, est obtenue. De par cette courbe, on note qu'un gain d'au moins 4,5dB est obtenu entre 2 et 30 GHz comme il a été annoncé précédemment. Cette courbe a été tracée dans les conditions où la tension drain-source des transistors est $V_{DS}$ = 4 V pour un courant de drain $I_D$ = 150 mA.

## Revendications

1. Circuit amplificateur distribué large bande constitué de plusieurs transistors à effet de champ dont les grilles sont connectées à des inductances de manière à former une ligne de transmission dite ligne de grille, dont les drains sont connectés à des inductances de manière à former une ligne de transmission dite ligne de drain, et dont les sources sont reliées à la masse, la distribution des étages le long de la ligne de grille et de drain étant faite de manière telle que ces lignes de grille et de drain sont périodiquement chargées par leur propre impédance et par les capacités de grille et de drain des transistors constituant ainsi des lignes dites artificielles, et telle qu'un signal d'entrée hyperfréquences est appliqué sur l'entrée de la ligne de grille et un signal de sortie hyperfréquences amplifié est prélevé sur la sortie de la ligne de drain, les extrémités des lignes de grille et de drain opposées aux entrées-sorties étant fermées sur des charges, et au moins une de ces extrémités de ligne comportant un circuit de polarisation, caractérisé en ce que l'extrémité de la ligne de drain opposée à la sortie est seule munie de moyens de polarisations tandis que l'extrémité de la ligne de grille opposée à l'entrée est munie de moyens pour compenser les variations de l'impédance caractéristique des lignes artificielles en fonction de la fréquence.

2. Circuit amplificateur selon la revendication 1, caractérisé en ce que les moyens pour compenser les variations des impédances caractéristiques sont constitués par des tronçons de lignes hyperfréquences en série avec la ligne de grille, entre lesquels sont connectés des tronçons de lignes ouvertes.

3. Circuit amplificateur selon la revendication 2, caractérisé en ce que les tronçons de lignes hyperfréquences en série sont au nombre de deux et les tronçons de lignes ouvertes sont au moins au nombre de un.

4. Circuit amplificateur selon l'une des revendications précédentes, caractérisé en ce que les moyens de polarisation sont constitués de tronçons de lignes hyperfréquences en sére avec la ligne de drain, entre lesquelles sont reliées des capacités, les secondes bornes de ces capacités étant d'autre part reliées à la masse.

5. Circuit amplificateur selon l'une des revendications précédentes caractérisé en ce que chaque charge est constituée par une résistance en série avec une capacité.

6. Circuit amplificateur selon l'une des revendications 1 à 5, caractérisé en ce qu'il est réalisé sur un substrat isolant complètement autonome dépourvu de polarisation extérieure.

7. Circuit amplificateur selon les revendications 1 à 6 caractérisé en ce que les transistors à effet de champ sont du type N implanté.

8. Circuit amplificateur selon l'une des revendications 1 à 7, caractérisé en ce que les lignes hyperfréquences sont du type microruban.

9. Circuit amplificateur selon l'une des revendications 1 à 8, caractérisé en ce que le substrat est en céramique par exemple de l'alumine.

10. Circuit amplificateur selon l'une des revendications 1 à 7, caractérisé en ce qu'il est monolithiquement intégré sur un substrat en un composé du groupe III-V.

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PROCEEDINGS OF THE 15th EUROPEAN MICROWAVE CONFERENCE, 9-13 septembre 1985, Société des Electriciens et des Electroniciens, pages 541-546, Microwave Exhibitions and Publishers Ltd,, Tunbridge Wells, Kent, GB; P. GAMAND: "A 0.1 to 25 GHz HMIC distributed amplifier on AL2O3 substrate" * Figure 4; page 542, lignes 11-34; page 542, ligne 45 - page 543, ligne 2 * | 1,4,5, 8-10 | H 03 F   3/60 |
| A | MICROWAVE JOURNAL, vol. 27, no. 4, avril 1984, pages 71-79, Dedham Massachusetts, US; Y. AYASLI: "Decade bandwidth amplification at microwave frequencies" * Figure 4; pages 71,72 * | 1,4,5, 8-10 | |
| A | 1982 IEEE MIT-S INTERNATIONAL MICROWAVE SYMPOSIUM DIGEST, 15-17 juin 1982, Dannas, Texas, pages 459-461, IEEE, New York, US; A.N. RIDDLE et al.: "Odd order impedance matching networks for low cost microwave integrated circuits" * Figure 3a; 1er paragraphe: "Experimental Results"; pages 459-460 * | 2,3 | DOMAINES TECHNIQUES RECHERCHES (Int. Cl.4)  H 03 F |

Le présent rapport de recherche a été établi pour toutes les revendications

| Lieu de la recherche | Date d'achèvement de la recherche | Examinateur |
|---|---|---|
| LA HAYE | 15-06-1987 | TYBERGHIEN G.M.P. |